# EUROPEAN PATENT SPECIFICATION

(11) **EP 4 766 618 B1**
(45) Date of publication and mention of the grant of the patent: **26.08.2026**
(21) Application number: 25744150.1
(22) Date of filing: 25.07.2025
(51) Int. Cl.: B64G 1/22, B64G 1/42, B64G 1/44, H02S 20/30, H10F 77/00

(54) **A SOLAR WING AND A SPACECRAFT COMPRISING SUCH SOLAR WING**
SOLARFLÜGEL UND RAUMFAHRZEUG MIT SOLCH EINEM SOLARFLÜGEL
AILE SOLAIRE ET ENGIN SPATIAL COMPRENANT UNE TELLE AILE SOLAIRE

(30) Priority: 12.11.2024 EP 24290038
(43) Date of publication of application: 01.07.2026
(73) Proprietor: Airbus Defence and Space SAS, 31402 Toulouse Cedex 4 (FR); Airbus Defence and Space GmbH, 82024 Taufkirchen (DE)
(72) Inventor: LOEHBERG, Andreas, 82024 Taufkirchen (DE); DELTOUR, Bernard, 31402 Toulouse (FR); HALA, Juergen, 82024 Taufkirchen (DE)
(74) Representative: Plasseraud IP
(86) International application number: PCT/EP2025/071471
(87) International publication number: WO 2026/104074

(56) References cited:
- EP-A1- 3 896 844
- EP-B1- 3 666 665
- FR-A1- 2 589 982
- FR-A1- 3 102 022
- US-A1- 2017 175 806
- US-A1- 2019 044 475

## Description

### Technical Field

This disclosure pertains to the field of spacecrafts such as satellites. More precisely, it concerns a solar wing for generating electricity to power the spacecraft and a spacecraft comprising such a solar wing.

### Background Art

In order to produce electricity for satellites, it is known to provide solar arrays structures, which can be in a stowed condition in the launch vehicle, and which can be deployed for use in a deployed configuration.

US 4 787 580 provides a solar array structure for use with satellites requiring large areas of solar arrays. Each array is a single continuous structure having continuous longitudinal members which in a stowed condition enable the panel to be wrapped around the satellite within its launch vehicle. In a deployed configuration, the longitudinal members are reconfigured to provide substantially increased stiffness in the direction of winding.

EP 1 043 228 discloses, in a solar panel, a first support member and a second support member overlying the first support member. The second support member is flexible whereas the first support member has a stiffness. There are also biasing means carried by the first support member for pushing opposite ends of the second support member toward one another to outwardly bow the second support member.

WO 2011/109436 discloses a deployable structure that may include a slit-tube longeron and a flat panel coupled with the slit-tube longeron. The slit-tube longeron may include a tubular member having a slit that runs along the longitudinal length of the slit-tube longeron. The deployable structure may be configured to couple with a satellite and to transform between a stowed state and a deployed state. The tubular member is substantially straight when the deployable structure is in the deployed state, and the tubular member is wrapped around the satellite when the deployable structure is in the stowed state. US2017175806 discloses, according to its abstract, a hinge assembly comprising first and second tape spring elements, wherein each of the spring elements is configured to connect a first element of a space structure to a second element of the space structure. Each of the first and the second tape spring elements is movable from a folded state into an unfolded state by releasing stored strain energy, to deploy the first and the second element of the space structure. The first tape spring element is connected to a first direct current source and configured to conduct direct current of a first polarity supplied to the first tape spring element from the first direct current source. The second tape spring element is connected to a second direct current source and configured to conduct direct current of a second polarity, opposite to the first polarity, supplied to the second tape spring element from the second direct current source.

There is a need to benefit from a solar wing that is simpler than the prior art.

### Summary

This disclosure improves the situation. It is proposed a solar wing for a spacecraft, the solar wing being configured to be movable between a stowed position and a deployed position, the solar wing comprising at least one solar panel positioned along a longitudinal axis, in the deployed position, each solar panel comprising a flexible sheet supporting solar cells, wherein the solar wing further comprises:
a. on each solar panel, at least two electrically conductive transversal bands fixed to and extending along the entire length of two opposite edges of the solar panel, the two electrically conductive transversal bands being transversal to the longitudinal axis and being electrically and mechanically connected to the solar cells,
b. a back-bone structure comprising at least one pair of electrically conductive C-shaped tape springs, said pair of electrically conductive C-shaped tape springs being fixed to said two electrically conductive transversal bands of said solar panel and configured to link said solar panel to a connecting area of the spacecraft, said at least one pair of electrically conductive C-shaped tape springs extending in at least one line in the deployed position from the connecting area to the solar panel that is distal from the spacecraft in the deployed position, the connecting area being configured to mechanically and electrically connect the solar wing to the spacecraft,
   wherein the transversal bands and the back-bone structure are connected to each other and are configured to transport electrical energy from the solar cells to the connecting area.

Advantageously the C-shaped tape springs performs the functions, of forming the structure of the solar wing, providing deployment and latch mechanism, and ensuring electrical power transfer. The solar wing is therefore composed of a small number of simple parts, thereby reducing the overall production costs. Stiffness and stability of the solar wing are sufficient for typical maneuvers.

Advantageously the rigidity is easily increased by setting the number of C-shaped tape springs in each line and by setting the number of lines.

The solar wing may comprise at least two solar panels adjacent to one another. Said pair of electrically conductive C-shaped tape springs may be fixed to the solar panels and configured to link the solar panels to one another.

The solar wing may comprise a plurality of brackets configured to mechanically connect the back-bone structure to the transversal bands and at least for some of the brackets to electrically connect the back-bone structure to the transversal bands.

At least some of the brackets may each be configured to hold at least two C-shaped tape springs positioned in the same line and to maintain a predetermined distance between C-shaped tape springs of the same line. The predetermined distance may be in the range 3 mm to 13 mm, preferably 6 mm to 10 mm and more preferably 7 mm to 9 mm.

The back-bone structure may comprise a plurality of lines.

Among the plurality of lines, at least two lines may diverge away from one another at a distal end of the solar wing.

Each line may comprise at least two C-shaped tape springs.

Adjacent solar panels may be facing each other in the stowed position. The C-shaped tape springs may be able to fold at 180° in the stowed position in a linking portion extending between the two adjacent solar panels and may be able to unfold in the deployed position.

The C profiles of two C-shaped tape springs in the same line may be oriented in the same direction and may be centered relative to each other or may be offset.

A spacecraft comprising at least one solar wing according to the above is also proposed.

### Brief Description of Drawings

Other features, details and advantages will be shown in the following detailed description and on the figures, on which:
[Fig. 1] is a schematic view in perspective showing an example of a spacecraft having a solar wing in the deployed position.
[Fig. 2] is a schematic view in perspective showing an example of brackets.
[Fig. 3] is a schematic partial view showing an example of a pair of C-shaped tape springs in a folded position.
[Fig. 4] is a schematic partial view of the pair of C-shaped tape springs of figure 3 in the deployed position.
[Fig. 5] is showing in a perspective and schematic view the spacecraft of figure 1, the solar wing being in the stowed position.
[Fig. 6] is a schematic view of an example of spacecraft having two solar wings, in the deployed position.

### Description of Embodiments

In the various figures, the same references designate identical or similar elements. For simplicity's sake, only the elements that are useful for understanding the described example are shown in the figures and are described in detail below.

In the following description, when referring to terms qualifying absolute position, such as the terms "front", "rear", "top", "bottom", "left", "right", etc., or relative ones, such as the terms "above", "below", "upper", "lower", etc., or to qualifiers of orientation, such as "horizontal", "vertical", etc., reference is made, unless otherwise specified, to the orientation of the figures.

Advantageously the spacecraft 100 has one or several simple solar wings 1 which are configured to be movable between a stowed position and a deployed position.

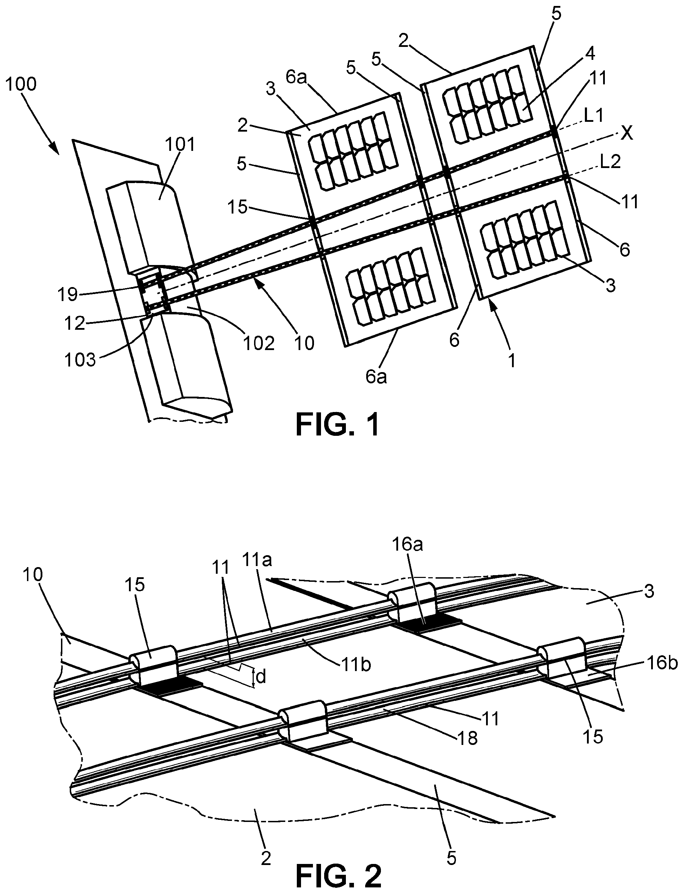

As shown in Figure 1, the solar wing 1, in the deployed position is linked to the spacecraft thanks to a support. The solar wing 1 comprises for example a connecting area 12 for connection to the spacecraft 100, especially to a spacecraft body 101 of the spacecraft 100. The spacecraft body 101 has for example two lateral supporting parts having a convex external shape, said two lateral supporting parts being connected to each other by a central part 102. Each of said two lateral parts and said central part have a thickness and are delimited by lateral flat surface. The connecting area 12 is for example in the lateral surface 103 of the central part 102.

The connecting area 12 comprises means to connect the solar wing 1 to the spacecraft 100, i.e. to the spacecraft body 101.

The solar wing 1 comprises at least one solar panel 2 deployed along a longitudinal axis X. Each solar panel 2 comprises a flexible sheet 3 supporting solar cells 4. The solar wing 1 comprises for example two solar panels 2 that are adjacent along the longitudinal axis X, one of them being close to the spacecraft body 101, or proximal, and the other one being distal relative to the spacecraft body 101. The flexible sheets 3 have for example a rectangular shape, having two opposite lateral edges 6a, parallel to the longitudinal axis X and two opposite edges 6 that are perpendicular to the longitudinal axis X.

The solar cells 4 are for example located in specific zones of the flexible sheets 3 of the solar panels 2, and positioned laterally relative to the longitudinal axis X and on one of the face or on both faces of the solar panel.

Each solar panel 2, comprises at least two electrically conductive transversal bands 5 fixed to two opposite edges 6 of the flexible sheets 3.

As shown in figure 1, the transversal bands 5 extend for example along the entire length of the edges 6. The transversal bands contribute to the rigidity of the solar panels 2. The transversal bands 5 are transversal to the longitudinal axis X. The transversal bands 5 are electrically and mechanically connected to the solar cells 4, for example through wiring connecting the solar cells 4 to the transversal bands 5. Advantageously, the electrically conductive transversal bands 5 provide stiffness to the solar panel 2 and transfer electricity produced by solar cells 4.

The solar wing 1 also comprises a back-bone structure 10 comprising at least one pair of electrically conductive C-shaped tape springs 11 fixed to said the solar panel 2 or panels of the solar wing and configured to link said solar panel 2 to the spacecraft body 101.

The back-bone structure 10 extends in at least one line in the deployed position from the connecting area 12 to the solar panel 2 that is distal from the spacecraft body 101 in the deployed position.

As shown in Figure 1, the solar wing comprises for example two lines L1 and L2. The backbone structure 10 therefore extends along these two lines L1 and L2 in the deployed position. The backbone structure 10 comprises, for example, two pairs of electrically conductive C-shaped tape springs 11, each pair extending along one of the two lines L1 and L2.

As shown in Figure 1, the two lines L1, L2 diverge for example away from one another at a distal end of the solar wing 1. In the deployed position, the backbone structure 10 therefore extends along two lines L1 and L2 from the spacecraft body 101 to the end of the solar panel 2 that is distal. The yoke of the solar wing is for example formed by the ends of the two lines of C-shaped tape springs.

As shown in Figure 1, the backbone structure 10, in the deployed position, faces the solar panels 2, with a determined distance with the flexible sheets 3. A linking portion 18 of the backbone structure 10, in the deployed position, also faces, for example, the free spaces between adjacent solar panels and the free space between the spacecraft body 110 and the solar panel 2 that is proximal.

Each conductive C-shaped tape spring 11 may be made in a single piece from one end at the connecting area 12 to the other end at the end of the distal solar panel 2.

The connecting area 12 is configured to mechanically and electrically connect the solar wing 1 to the body of the spacecraft 100. The transversal bands 5 and the back-bone structure 10 are also mechanically and electrically connected and are configured to transport electrical energy from the solar cells 4 to the connecting area 12. This means that electricity is transferred from the solar cells 4 to the spacecraft 100 via at least some of the transversal bands 5 and via at least some of the C-shaped tape springs 11 of the back-bone structure 10. The transversal bands 5 and the back-bone structure 10 also provide stiffness to the solar wing 1 in the deployed position.

As shown in figure 1, the solar wing 1 comprises for example two solar panels 2 adjacent to one another, in the deployed position. Each electrically conductive C-shaped tape spring 11 of the backbone structure is fixed to the solar panels 2. At least a pair of C-shaped tape springs is used for the current transfer. C-shaped tape springs may be grouped by two, three, four or more in a same line, depending on the needed rigidity of this line. Depending on the needed global rigidity, one, two, three or more lines may be used for constituting the backbone, each line comprising one, two, three or more C-shaped tape springs.

The solar wing 1 comprises for example a plurality of brackets 15 configured to mechanically connect the back-bone structure 10 to the transversal bands 5 and, at least for some of these brackets 15, to electrically connect the back-bone structure 10 to the transversal bands 5. The brackets connect, for example, C-shaped tape springs of the backbone, to each transversal band.

As shown in figure 2, the brackets 15 of the first line are for example fixed on supports 16a made of an isolating material whereas the brackets of the second line are fixed on supports 16b enabling the transmission of electrical current from the solar panel.

The backbone structure 10 is for example connected exclusively, via the brackets, to the transversal bands 5.

As shown in Figure 1, the connection area 12 comprises for example a plurality of brackets 19 fixed to the end of the C-shaped tape springs 11. All the brackets are for example identical. The function of brackets 19, in the connection area 12, is for example to mechanically and electrically connect the C-shaped tape springs 11 to the spacecraft body 101. Some of the brackets perform for example a mechanical link whereas others perform an electrical and mechanical link.

As shown in figure 2, the brackets 15 are each configured to hold a plurality of C-shaped tape springs, for example two C-shaped tape springs 11a, 11b of a same pair. The plurality of C-shaped tape springs maintained by a bracket are positioned at a predetermined distance, referenced d, between adjacent C-shaped tape springs 11a, 11b of the same line, L1 or L2. The predetermined distance d may be in the range 3 mm to 13 mm, preferably 6 mm to 10 mm and more preferably 7 mm to 9 mm.

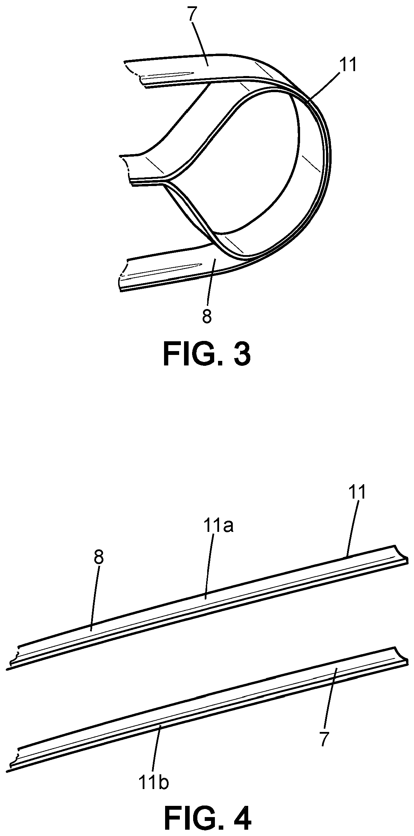

As shown in Figure 3, in the stowed position, the C-shaped tape springs 11 are for example able to fold at 180°, in the portion 18 extending from a solar panel, for example between adjacent solar panels 2. The contact between two C-shaped tape springs potentially forming two distinct electrical lines is acceptable in the stowed position because no electrical power is produced by the solar panels.

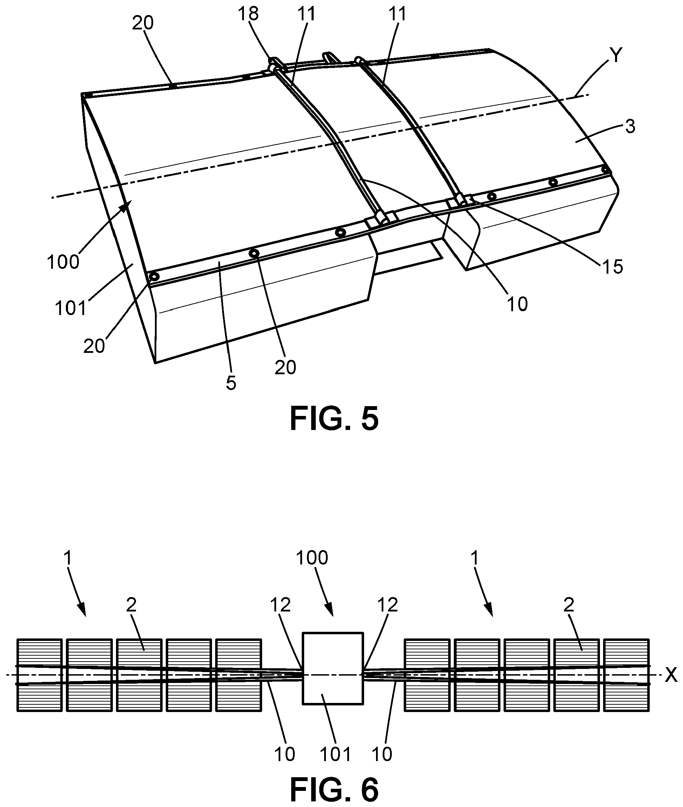

As shown in Figure 5, adjacent solar panels 2 are for example facing each other in the stowed position. C-shaped tape springs are in a folded position, which corresponds to the stowed position. As shown in Figure 3, the external C-shaped tape spring 11 is for example curved in a C shape whereas the internal C-shaped tape spring forms a loop.

As shown in Figure 4, the C-shaped tape springs 11 tend to unfold in the deployed position, at 180 degrees. Due to their C-profile and material, C-shaped tape springs work like a spring, tending to unfold on their own. C-shaped tape springs of a same line then extend straight and parallel to each other. The C-profiles in a same line is for example oriented in a same direction. The C-profile is for example the same along the entire length of the C-shaped tape spring.

As shown in figure 4, the C profiles of two C-shaped tape springs 11a, 11b in the same line are for example oriented in the same direction and are centered relative to each other.

Alternatively the C-shaped tape springs of a same line are offset.

Alternatively the C-shaped tape springs of a same line are for example oriented in opposite directions.

As shown in Figure 5, the solar wing 1 in the stowed position is compact. Advantageously the flexible solar sheets are for example stacked and pressed against the support. The C-shaped tape springs 11 are for example folded at 180 degrees between the solar panels and at 90 degrees between the connection area and the first solar panel. The solar panels 2 are for example folded against the spacecraft body 101 in a z-manner.

As shown in Figure 5, the spacecraft 100 comprises for example a support part having a curved profile so that the solar wing 1 is tensed against the curved support. The stacked solar wing is pressed against the curved support which has a convex shape. The transversal bands 5 extend for example parallel to curved support. Fixing elements 20 which can be released maintain for example the stack against the support, by applying an effort on the transversal band. The C-shaped tape springs 11 are advantageously able to follow the curvature of the support, in the stowed position.

As shown in Figure 6, the spacecraft 100 comprises for example two solar wings 1 according to the invention. The two solar wings 1 extend for example opposite to each other, on each side of the spacecraft.

Advantageously, each solar wing is able to comprise an important number of solar sheets, such as five solar sheets, ten solar sheets, twenty solar sheets or even more, such that cheap low power solar sheets may be used for space mission requiring relatively high electrical power.

## Claims

1. A solar wing (1) for a spacecraft (100), the solar wing (1) being configured to be movable between a stowed position and a deployed position, the solar wing (1) comprising at least one solar panel (2) positioned along a longitudinal axis (X), in the deployed position, each solar panel (2) comprising a flexible sheet (3) supporting solar cells (4), wherein the solar wing (1) further comprises:
a. on each solar panel (2), at least two electrically conductive transversal bands (5) fixed to and extending along the entire length of two opposite edges (6) of the solar panel (2), the two electrically conductive transversal bands (5) being transversal to the longitudinal axis (X) and being electrically and mechanically connected to the solar cells (4),
b. a back-bone structure (10) comprising at least one pair of electrically conductive C-shaped tape springs (11), said pair of electrically conductive C-shaped tape springs (11) being fixed to said two electrically conductive transversal bands (5) of said solar panel (2) and configured to link said solar panel (2) to a connecting area (12) of the spacecraft (100), said at least one pair of electrically conductive C-shaped tape springs (11) extending in at least one line in the deployed position from the connecting area (12) to the solar panel (2) that is distal from the spacecraft (100) in the deployed position, the connecting area (12) being configured to mechanically and electrically connect the solar wing to the spacecraft (100),
wherein the transversal bands (5) and the back-bone structure (10) are connected to each other and are configured to transport electrical energy from the solar cells (4) to the connecting area (12).

2. The solar wing (1) according to claim 1, wherein the solar wing (1) comprises at least two solar panels (2) adjacent to one another, said pair of electrically conductive C-shaped tape springs (11) being fixed to the solar panels (2) and configured to link the solar panels (2) to one another.

3. The solar wing (1) according to claim 1 or 2, comprising a plurality of brackets (15) configured to mechanically connect the back-bone structure (10) to the transversal bands (5) and at least for some of the brackets to electrically connect the back-bone structure (10) to the transversal bands (5).

4. The solar wing (1) according to claim 3, wherein at least some of the brackets (15) are each configured to hold at least two C-shaped tape springs (11a, 11b) positioned in the same line and to maintain a predetermined distance (d) between C-shaped tape springs (11a, 11b) of the same line, the predetermined distance (d) being in the range 3 mm to 13mm, preferably 6 mm to 10 mm and more preferably 7mm to 9mm.

5. The solar wing (1) according to any preceding claim, wherein the back-bone structure (10) comprises a plurality of lines (L1, L2).

6. The solar wing (1) according to claim 5, wherein among the plurality of lines (L1, L2), at least two lines (L1, L2) diverge away from one another at a distal end of the solar wing.

7. The solar wing (1) according to any preceding claim, wherein each line (L1; L2) comprises at least two C-shaped tape springs (11).

8. The solar wing (1) according to any preceding claim, wherein adjacent solar panels are facing each other in the stowed position, the C-shaped tape springs (11) being able to fold at 180° in the stowed position in a linking portion (18) extending between the two adjacent solar panels (2) and being able to unfold in the deployed position.

9. The solar wing (1) according to any preceding claim, wherein the C profiles of two C-shaped tape springs (11a, 11b) in the same line are oriented in the same direction and are centered relative to each other or are offset.

10. Spacecraft (100) comprising at least one solar wing (1) according to any preceding claim.

## Patentansprüche

1. Solarflügel (1) für ein Raumfahrzeug (100), wobei der Solarflügel (1) so konfiguriert ist, dass er zwischen einer verstauten Position und einer entfalteten Position beweglich ist, wobei der Solarflügel (1) mindestens ein Solarpaneel (2) umfasst, das entlang einer Längsachse (X) in der entfalteten Position angeordnet ist, wobei jedes Solarpaneel (2) eine flexible Folie (3) umfasst, die Solarzellen (4) trägt, wobei der Solarflügel (1) ferner umfasst:
a. an jedem Solarpaneel (2) mindestens zwei elektrisch leitfähige Querbänder (5), die an zwei gegenüberliegenden Kanten (6) des Solarpaneels (2) befestigt sind und sich über deren gesamte Länge erstrecken, wobei die beiden elektrisch leitfähigen Querbänder (5) quer zur Längsachse (X) verlaufen und elektrisch und mechanisch mit den Solarzellen (4) verbunden sind,
b. eine Rückgratstruktur (10), umfassend mindestens ein Paar elektrisch leitfähiger C-förmiger Bandfedern (11), wobei das Paar elektrisch leitfähiger C-förmiger Bandfedern (11) an den beiden elektrisch leitfähigen Querbändern (5) des Solarpaneels (2) befestigt und so konfiguriert ist, dass es das Solarpaneel (2) mit einem Verbindungsbereich (12) des Raumfahrzeugs (100) verbindet, wobei sich das mindestens eine Paar elektrisch leitfähiger C-förmiger Bandfedern (11) in mindestens einer Linie in der entfalteten Position vom Verbindungsbereich (12) zu dem Solarpaneel (2) erstreckt, das in der entfalteten Position distal vom Raumfahrzeug (100) ist, wobei der Verbindungsbereich (12) so konfiguriert ist, dass er den Solarflügel mechanisch und elektrisch mit dem Raumfahrzeug (100) verbindet,
wobei die Querbänder (5) und die Rückgratstruktur (10) miteinander verbunden und so konfiguriert sind, dass sie elektrische Energie von den Solarzellen (4) zum Verbindungsbereich (12) transportieren.

2. Der Solarflügel (1) nach Anspruch 1, wobei der Solarflügel (1) mindestens zwei zueinander benachbarte Solarpaneele (2) umfasst, wobei das Paar elektrisch leitfähiger C-förmiger Bandfedern (11) an den Solarpaneelen (2) befestigt und so konfiguriert ist, dass es die Solarpaneele (2) miteinander verbindet.

3. Der Solarflügel (1) nach Anspruch 1 oder 2, umfassend eine Vielzahl von Halterungen (15), die so konfiguriert sind, dass sie die Rückgratstruktur (10) mechanisch mit den Querbändern (5) verbinden und zumindest für einige der Halterungen die Rückgratstruktur (10) elektrisch mit den Querbändern (5) verbinden.

4. Der Solarflügel (1) nach Anspruch 3, wobei zumindest einige der Halterungen (15) jeweils so konfiguriert sind, dass sie mindestens zwei C-förmige Bandfedern (11a, 11b) halten, die in derselben Linie positioniert sind, und einen vorbestimmten Abstand (d) zwischen C-förmigen Bandfedern (11a, 11b) derselben Linie aufrechterhalten, wobei der vorbestimmte Abstand (d) im Bereich von 3 mm bis 13 mm, vorzugsweise 6 mm bis 10 mm und besonders bevorzugt 7 mm bis 9 mm liegt.

5. Der Solarflügel (1) nach einem der vorhergehenden Ansprüche, wobei die Rückgratstruktur (10) eine Vielzahl von Linien (L1, L2) umfasst.

6. Der Solarflügel (1) nach Anspruch 5, wobei unter der Vielzahl von Linien (L1, L2) mindestens zwei Linien (L1, L2) an einem distalen Ende des Solarflügels voneinander divergieren.

7. Der Solarflügel (1) nach einem der vorhergehenden Ansprüche, wobei jede Linie (L1; L2) mindestens zwei C-förmige Bandfedern (11) umfasst.

8. Der Solarflügel (1) nach einem der vorhergehenden Ansprüche, wobei benachbarte Solarpaneele in der verstauten Position einander zugewandt sind, wobei die C-förmigen Bandfedern (11) in der verstauten Position in einem Verbindungsabschnitt (18), der sich zwischen den beiden benachbarten Solarpaneelen (2) erstreckt, um 180° gefaltet werden können und sich in der entfalteten Position entfalten können.

9. Der Solarflügel (1) nach einem der vorhergehenden Ansprüche, wobei die C-Profile von zwei C-förmigen Bandfedern (11a, 11b) in derselben Linie in derselben Richtung ausgerichtet und zueinander zentriert oder versetzt sind.

10. Raumfahrzeug (100), umfassend mindestens einen Solarflügel (1) nach einem der vorhergehenden Ansprüche.

## Revendications

1. Aile solaire (1) pour un engin spatial (100), l'aile solaire (1) étant configurée pour être mobile entre une position repliée et une position déployée, l'aile solaire (1) comprenant au moins un panneau solaire (2) positionné le long d'un axe longitudinal (X), dans la position déployée, chaque panneau solaire (2) comprenant une feuille souple (3) supportant des cellules solaires (4), dans laquelle l'aile solaire (1) comprend en outre :
a. sur chaque panneau solaire (2), au moins deux bandes transversales électriquement conductrices (5) fixées à deux bords opposés (6) du panneau solaire (2) et s'étendant sur toute la longueur de ceux-ci, les deux bandes transversales électriquement conductrices (5) étant transversales à l'axe longitudinal (X) et étant connectées électriquement et mécaniquement aux cellules solaires (4),
b. une structure de squelette (10) comprenant au moins une paire de ressorts à ruban en forme de C électriquement conducteurs (11), ladite paire de ressorts à ruban en forme de C électriquement conducteurs (11) étant fixée auxdites deux bandes transversales électriquement conductrices (5) dudit panneau solaire (2) et configurée pour relier ledit panneau solaire (2) à une zone de connexion (12) de l'engin spatial (100), ladite au moins une paire de ressorts à ruban en forme de C électriquement conducteurs (11) s'étendant dans au moins une ligne dans la position déployée depuis la zone de connexion (12) jusqu'au panneau solaire (2) qui est distal de l'engin spatial (100) dans la position déployée, la zone de connexion (12) étant configurée pour connecter mécaniquement et électriquement l'aile solaire à l'engin spatial (100),
dans laquelle les bandes transversales (5) et la structure de squelette (10) sont connectées l'une à l'autre et sont configurées pour transporter de l'énergie électrique des cellules solaires (4) à la zone de connexion (12).

2. L'aile solaire (1) selon la revendication 1, dans laquelle l'aile solaire (1) comprend au moins deux panneaux solaires (2) adjacents l'un à l'autre, ladite paire de ressorts à ruban en forme de C électriquement conducteurs (11) étant fixée aux panneaux solaires (2) et configurée pour relier les panneaux solaires (2) l'un à l'autre.

3. L'aile solaire (1) selon la revendication 1 ou 2, comprenant une pluralité de supports (15) configurés pour connecter mécaniquement la structure de squelette (10) aux bandes transversales (5) et au moins pour certains des supports pour connecter électriquement la structure de squelette (10) aux bandes transversales (5).

4. L'aile solaire (1) selon la revendication 3, dans laquelle au moins certains des supports (15) sont chacun configurés pour maintenir au moins deux ressorts à ruban en forme de C (11a, 11b) positionnés dans la même ligne et pour maintenir une distance prédéterminée (d) entre des ressorts à ruban en forme de C (11a, 11b) de la même ligne, la distance prédéterminée (d) étant dans la plage de 3 mm à 13 mm, de préférence de 6 mm à 10 mm et plus préférablement de 7 mm à 9 mm.

5. L'aile solaire (1) selon l'une quelconque des revendications précédentes, dans laquelle la structure de squelette (10) comprend une pluralité de lignes (L1, L2).

6. L'aile solaire (1) selon la revendication 5, dans laquelle parmi la pluralité de lignes (L1, L2), au moins deux lignes (L1, L2) divergent l'une de l'autre à une extrémité distale de l'aile solaire.

7. L'aile solaire (1) selon l'une quelconque des revendications précédentes, dans laquelle chaque ligne (L1 ; L2) comprend au moins deux ressorts à ruban en forme de C (11).

8. L'aile solaire (1) selon l'une quelconque des revendications précédentes, dans laquelle des panneaux solaires adjacents se font face dans la position repliée, les ressorts à ruban en forme de C (11) étant capables de se plier à 180° dans la position repliée dans une partie de liaison (18) s'étendant entre les deux panneaux solaires adjacents (2) et étant capables de se déplier dans la position déployée.

9. L'aile solaire (1) selon l'une quelconque des revendications précédentes, dans laquelle les profils en C de deux ressorts à ruban en forme de C (11a, 11b) dans la même ligne sont orientés dans la même direction et sont centrés l'un par rapport à l'autre ou sont décalés.

10. Engin spatial (100) comprenant au moins une aile solaire (1) selon l'une quelconque des revendications précédentes.
